(19) Europäisches Patentamt
European Patent Office
Office européen des brevets

(11) Publication number: **0 130 910**
**B1**

(12) **EUROPEAN PATENT SPECIFICATION**

(45) Date of publication of patent specification: **05.09.90**

(51) Int. Cl.$^5$: **G 11 C 7/00**

(21) Application number: **84401375.5**

(22) Date of filing: **28.06.84**

# (54) A sense amplifier.

(30) Priority: **30.06.83 JP 118618/83**

(43) Date of publication of application:
**09.01.85 Bulletin 85/02**

(45) Publication of the grant of the patent:
**05.09.90 Bulletin 90/36**

(84) Designated Contracting States:
**DE FR GB**

(56) References cited:
**EP-A-0 056 433**
**US-A-4 169 233**

(73) Proprietor: **FUJITSU LIMITED**
**1015, Kamikodanaka Nakahara-ku**
**Kawasaki-shi Kanagawa 211 (JP)**

(72) Inventor: **Suzuki, Yasuo**
**11-16, Shiratoridai Midori-ku**
**Yokohama-shi Kanagawa, 227 (JP)**
Inventor: **Hirao Hiroshi**
**2223, Noborito Tama-ku**
**Kawasaki-shi Kanagawa, 214 (JP)**
Inventor: **Suzuki, Yasuaki**
**878, Shimonoge Takatsu-ku**
**Kawasaki-shi Kanagawa, 213 (JP)**

(74) Representative: **Descourtieux, Philippe et al**
**CABINET BEAU de LOMENIE 55 rue d'Amsterdam**
**F-75008 Paris (FR)**

**EP 0 130 910 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a sense amplifier for a semiconductor memory device, in particular, to that suited to a multi-level memory in which each memory cell stores a data represented by binary bits more than one.

There has been proposed a concept of multi-level memory which is expected as a breakthrough for the capacity limitation problem of semiconductor memory devices. (Electronics, October 39, 1980, p.39, ibid. June 30, 1982, p.81, etc.) This technique is for increasing the capacity of a memory device with a constant chip size without increasing integration density. Some of four-level type memory devices have been put into practical application as ROMs (Read Only Memories). In such ROMs, the level of read out signal from each memory cell is related to one of the four states (data) represented by two bits of binary. These data are usually written in as the difference of the conductivity of the MOS transistor constituting a memory cell, during manufacturing process of the memory device by altering the size of the gate area of each transistor. Therefore, such ROM fall into the category of mask ROM.

In case of a four-level memory device, the level of each read-out signal is compared with three reference voltages, accordingly, it is necessary to implement at least three sense amplifiers each of which receives one of the three different reference voltages. Fig. 1 is a partial circuit diagram of a four-level ROM device, showing a memory cell $M_C$ and sensing facilities including a load circuit LOAD, a column select transistor $Q_C$, and three sense amplifiers, $SA_1$, $SA_2$ and $SA_3$, whose inputs are commonly connected to the data bus. In Fig. 1, the $Q_{D1}$ designates a transistor for discharging the bit line prior to the selection of column and row. As seen in Fig. 1, when the gate of LOAD is opened and the column select signal COL and row select signal ROW are respectively applied to the gates of the transistor $Q_C$ and the memory cell $M_C$, a read-out signal of a specified level corresponding to the data stored in the memory cell $M_C$ is generated on the data bus and is applied to the sense amplifiers $SA_1$, $SA_2$ and $SA_3$, simultaneously.

Sense amplifiers typically employed for memory devices are classified into two kinds; the one is a type of differential amplifier, and the other is that comprising a flip-flop circuit. A sense amplifier of the former type for sensing a multiple bit ROM has been disclosed in the U.S. Patent 4,287,570 filed September 1, 1981, for instance. From the point of view of sensitivity, a sense amplifier of the flip-flop type should be more advantageous than a sense amplifier of the differential amplifier type. U.S. Patent 4,163,233, for example, discloses a radiation hardened CMOS sense amplifier featuring two cross-coupled inverter amplifier stages having components that can automatically compensate for the effect of electrical parameter nonuniformities. However, it seems that there has been so far no disclosure of a flip-flop type sense amplifier which would be adapted to be used in multi-level memory devices. Though there are a lot of disclosures of flip-flop type sense amplifiers for the use in RAMs (Random Access Memories), such sense amplifier cannot be employed in the multi-level memory devices. This is due to the following problems.

In a RAM, each input signal is two level, and the sense amplifier is only required to discriminate read-out signals whose levels change within a narrow range 1 volt just below the power source voltage. On the other hand, in the four-level memory device, for example, three sense amplifiers must respond to four-level input signals varying in a range of a few volts, and it is necessary to provide means for isolating each flip-flop type sense amplifier to let it function independently from the others. Furthermore, the solutions for these problems formerly resulted in the increase of operational delay in the flip-flop type sense amplifiers, particularly in those for ROMs.

### Summary of the invention

Therefore, it is the primary object of the present invention to provide a flip-flop type sense amplifier which is adaptable to a multi-level memory device, and is particularly suited to a multi-level ROM device.

The sense amplifier of the present invention is defined in Claim 1.

The objects, features and advantages of the present invention will appear more fully from the following description.

### Brief description of the drawings

Fig. 1 is a circuit diagram showing a part of a four-level ROM;

Fig. 2 is a circuit diagram embodying a sense amplifier of the present invention;

Fig. 3 is a schematic diagram showing the input timing of controlling pulses; and

Figs. 4(A) and 4(B) are schematic diagrams showing potential changes in a sense amplifier.

Fig. 5 is a circuit diagram of a decoder for converting output signals from three sense amplifiers into a two binary bits expression;

### Preferred embodiment of the invention

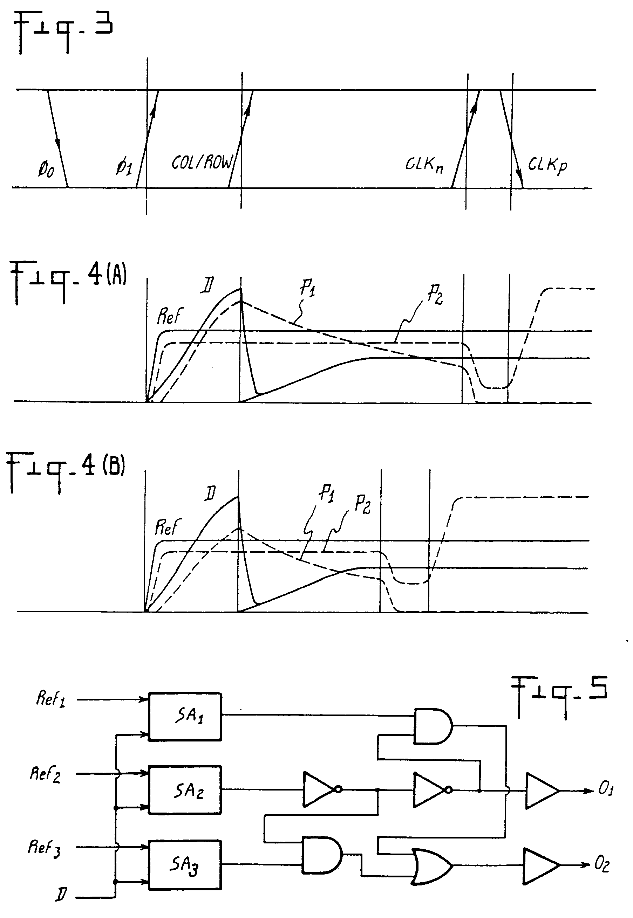

Fig. 2 is a circuit diagram embodying a sense amplifier of the present invention. In Fig. 2, $Q_1$ and $Q_2$ denote n-channel MOS transistors, and $Q_3$ and $Q_4$ (both attached with an arrowhead each) denote p-channel MOS transistors. Therefore each pair of $Q_1$ and $Q_3$, and $Q_2$ and $Q_4$ constitutes a CMOS inverter. These CMOS inverters are cross-coupled each other of their input terminals (common gate) and output terminals (nodes), hence form a flip-flop circuit. To the nodes $P_1$ and $P_2$ of the CMOS inverters, a couple of buffer circuits, the first comprising n-channel MOS transistors $Q_7$ and $Q_8$, and the second comprising

n-channel MOS transistors $Q_9$ and $Q_{10}$, are respectively connected. That is, the conduction channels in each pair of transistors $Q_7$ and $Q_8$ and transistors $Q_9$ and $Q_{10}$ are linked in series between a positive potential source ($V_{cc}$) and a negative potential source ($V_{ss}$), and the junction in each transistor pair is connected to each of the nodes $P_1$ and $P_2$, respectively. Therefore, the buffer circuits are formed in a source follower mode. The gate of the transistor $Q_7$ receives a read-out signal D, while the gate of the transistor $Q_9$ receives a reference voltage Ref. The transistors $Q_8$ and $Q_{10}$ are designed to have a relatively lower conductance (gm) compared to that of the transistors $Q_7$ and $Q_9$, hence the potentials at the nodes $P_1$ and $P_2$ change to be approximately equal to the level of D and Ref, respectively, during the stand-by sequence (the period in which the flip-flop circuit is not activated to output a full logic level signal).

To the common source of the n-channel transistors $Q_1$ and $Q_2$, and that of the p-channel transistors $Q_3$ and $Q_4$, a couple of switching circuits, the first comprising a p-channel MOS transistor $Q_5$ and an n-channel MOS transistor $Q_6$, the second comprising a p-channel transistor $Q_{11}$ and n-channel transistor $Q_{12}$, are respectively connected. Therefore, each of the switching circuits has CMOS inverter configuration. The conduction channel of a CMOS inverter constituting each switching circuit is connected between a positive potential source ($V_{cc}$) and a negative potential source ($V_{ss}$), and the common gate of the CMOS inverter constituting the first switching circuit receives a first clock signal, $CLK_n$, and the common gate of the CMOS inverter constituting the second switching circuit receives a second clock signal, $CLK_p$. The wave forms of the clock signals are shown in Fig. 3.

For sensing the read-out signal from a four-level memory cell, three sense amplifiers $SA_1$, $SA_2$ and $SA_3$ each having the circuit configuration as shown in Fig. 2 are implemented. Reference voltage signals $Ref_1$, $Ref_2$ and $Ref_3$ differing from one another in level are respectively input to each of the sense amplifiers. Thanks to the buffer circuit, each of the three sense amplifiers $SA_1$, $SA_2$ and $SA_3$ whose input terminals are connected commonly to the data bus is isolated and can operate independently from the others. For instance, when the level of the read-out signal D and the levels of the reference signals $Ref_1$, $Ref_2$ and $Ref_3$ are in the following relation, the potential at the node $P_1$ of the sense amplifier $SA_1$ is pulled down to the level of the negative potential source $V_{ss}$ (usually the ground level) during latching operation.

$$Ref_1>D>Ref_2>Ref_3$$

However, since each node $P_1$ of the sense amplifiers $SA_2$ and $SA_3$ is isolated by the buffer circuit, the level at the node $P_1$ of each of the sense amplifiers $SA_2$ and $SA_3$ can be correctly pulled up to the level of the positive potential source $V_{cc}$ independently from the pull-down in the sense amplifier $SA_1$.

Thus, any multi-level read-out signal having a level in the range between the highest reference voltage $Ref_1$ and the lowest reference voltage $Ref_3$ can be discriminated. It is obvious that such buffer circuit is unnecessary in the sense amplifier for an ordinary two-level memory device.

It is well known that CMOS configuration can provide a circuit of low power dissipation, however, further advantage of the CMOS is utilized in this invention. That is, a flip-flop circuit comprising CMOS inverters can operate to provide a full logic level output signal even either when both of the potentials at the nodes $P_1$ and $P_2$ are higher than the threshold voltage $V_{th(p)}$ of the p-channel MOS transistors $Q_3$ and $Q_4$ or when both of the potentials at the nodes $P_1$ and $P_2$ are lower than the threshold voltage $V_{th(n)}$ of the n-channel MOS transistors $Q_1$ and $Q_2$. In Fig. 2, if the potential $V(P_1)$ at the node $P_1$ and the potential $V(P_2)$ at the node $P_2$ are in the following relation, for example,

$$V_{th(n)}>V(P_2)>V(P_1),$$

both of the n-channel MOS transistors $Q_1$ and $Q_2$ are initially in OFF state. However, the positive feedback loop for amplifying the potential difference between the nodes $P_1$ and $P_2$ is maintained by the p-channel MOS transistors $Q_3$ and $Q_4$, hence the flip-flop circuit can operate to output full logic level signals. Similarly, the operation of the flip-flop circuit under a potential condition such as

$$V_{cc}-|V_{th(p)}|<V(P_2)<V(P_1),$$

for example, can also be accomplished by the positive feedback loop consisting of the n-channel MOS transistors $Q_1$ and $Q_2$. Therefore, the use of CMOS flip-flop circuit eliminates need for designing the flip-flop circuit for each sense amplifier individually to match the reference voltage input to the sense amplifier. That is, it is possible to produce sense amplifiers $SA_1$, $SA_2$ and $SA_3$ which have identical circuit parameters, hence reducing cost and turn around time in the manufacturing.

The function of the CMOS switching circuits connected to each common source of the flip-flop circuit is explained in connection with the wave form of the read-out signal D and the potential change at the nodes $P_1$ and $P_2$. Referring to Figs. 1 and 3, in the stand-by sequence, a control signal $\phi_o$ (which is for resetting the bit line to the ground level) turns to low level, hence the memory cell $M_C$ is ready for operation, then the gate of LOAD is open by the input of a control signal $\phi_1$. Subsequently to the above, when the column select signal COL and the row select signal ROW which are respectively input to the gates of the column select transistor $Q_C$ and the memory cell $M_C$ turn to high level, a read-out signal D having level corresponding to the conductance (gm) of the selected memory cell is generated on the bit line. At the

same time, the reference voltage Ref of each predetermined level is generated in each of the three reference voltage signal generating circuits (not shown). The read-out signal D on the bit line is input commonly through the data bus to the sense amplifiers $SA_1$, $SA_2$ and $SA_3$, while three reference voltages $Ref_1$, $Ref_2$ and $Ref_3$ are respectively input to the sense amplifiers $SA_1$, $SA_2$ and $SA_3$.

Figs. 4(A) and 4(B) are schematic diagrams showing the wave forms of the read-out voltage signal D, the reference voltage Ref, and the potentials at the nodes $P_1$ and $P_2$ of the flip-flop circuit shown in Fig. 2. Referring to Fig. 1 and Fig. 4(A), when the gate of the LOAD connected to the data bus is opened by incoming of the control signal $\phi_1$, steep rise of potential on the data bus occurs as shown by the curve D in Fig. 4(A). On the other hand, when the column select transistor $Q_C$ turns to ON by incoming of the column select signal COL, the potential falls very sharply, then tends to increase slowly to reach a steady level determined by the gm of the selected memory cell. This potential change in the curve D is due to the difference in the parasitic capacity of the data bus and that of the bit line. That is, the parasitic capacity of the data bus is substantially small compared to that of the bit line, accordingly, the time constant of the potential change on the data bus is small so long as the column select transistor $Q_C$ is OFF, but it becomes large after the column select transistor $Q_C$ has turned ON. Thus, the potential on the data bus rises steeply up to the level approximately equal to the positive potential source $V_{cc}$. The potential fall occurring just after the turn on of the column select transistor $Q_C$ appears because the bit line has been reset to be in the ground level by the incoming of the control signal $\phi_o$, as described above. Thus, the transient peak appears in the read-out voltage signal D. On the other hand, the potential change in the Ref is rather rapid and monotonous as shown by the curve Ref in Fig. 4(A).

Potential change at the nodes $P_1$ and $P_2$ occurs as shown by the dashed line curves in the Fig. 4(A), in response to the changes of the read-out voltage signal D and the reference voltage Ref. The potential at the node $P_1$ rises sharply as in the rise of the potential D on the data bus, and reaches a level approximately equal to that of the D, (in the strict sense, $P_1$ is lower than D by $V_{th}$, the threshold voltage of the transistor $Q_7$ of the first buffer circuit: see Fig. 2), but it decreases rather slowly to reach a steady level instead. The potential at the node $P_2$ changes approximately in parallel to the curve of the reference voltage Ref and reaches a steady level (the level at the node $P_2$ is lower than Ref by $V_{th}$, the threshold voltage of the transistor $Q_9$ of the second buffer circuit: see Fig. 2). The large time constant in the fall of the level at the node $P_1$ is due to the small conductance (gm) of the bias transistor $Q_8$ comprising the first buffer circuit.

In the course of reaching steady level, each of the curves representing the changes of the potentials at the nodes $P_1$ and $P_2$ cross each other, if the level of the read-out voltage signal D is lower than the level of the reference voltage Ref. The timing of the crossing depends on the heights of $P_1$ and $P_2$ at their steady levels. For example, in the four-level memory device, the largest delay of the timing occurs in the sense amplifier $SA_3$ when the lowest level read-out signal is input. Therefore, the timing to initiate the latching operation of the flip-flop circuits cannot be earlier than the above largest delay.

However, in the sense amplifier of the present invention, earlier latching operation can be accomplished as follows. Referring to Fig. 2 and Fig. 3, the second clock signal $CLK_p$ is in high level during the stand-by sequence, hence the transistor $Q_{12}$ in the CMOS inverter constituting the second switching circuit is in ON state, and the common source of the p-channel transistors $Q_3$ and $Q_4$ of the flip-flop circuit is connected to the negative potential source $V_{ss}$. Under this condition, charges accumulated in the capacity attached to the node $P_1$, in response to the transient rise in the potential D, are discharged through the transistors $Q_3$ and $Q_{12}$ as far as the potential at the node $P_1$ is kept higher than the potential at the node $P_2$ by $V_{th(p)}$, the threshold voltage of the p-channel transistor $Q_3$. Consequently, the height of the transient peak in the potential change at the node $P_1$ is reduced, and further, the fall subsequent to the transient peak is accelerated, as shown in Fig. 4(B).

At the same time, the transistor $Q_5$ in the CMOS inverter constituting the first switching circuit is in ON state because the first clock signal $CLK_n$ is in low level, hence the common source of the n-channel transistors $Q_1$ and $Q_2$ of the flip-flop circuit is connected to the positive potential source $V_{cc}$. Under this condition, the charge-up of the capacity attached to the node $P_2$ is accelerated through the transistor $Q_2$ which is in ON state as far as the potential at the node $P_1$ is kept higher than the potential at the node $P_2$ by $V_{th(n)}$, the threshold voltage of the n-channel transistor $Q_2$. (Note that, in this sequence, transistor $Q_1$ is in OFF state).

As the result of both accelerations in the discharge of the capacity attached to the node $P_1$ and in the charge-up of the capacity attached to the node $P_2$, the crossing timing of the potentials at the nodes $P_1$ and $P_2$ is advanced, as shown in Fig. 4(B), and earlier initiation of the latching operation of the flip-flop circuit can be accomplished.

After the crossing, the first clock signal $CLK_n$ turns to high level, hence, in the first switching circuit, transistor $Q_5$ is turned to OFF state while transistor $Q_6$ is turned to ON state. Subsequent to the change of the first clock signal $CLK_n$, the second clock signal $CLK_p$ turns to low level, hence, in the second switching circuit, transistor $Q_{12}$ is turned to OFF state while transistor $Q_{11}$ is turned to ON state. Thus, the common source of the n-channel transistors $Q_1$ and $Q_2$ and that of the p-channel transistors $Q_3$ and $Q_4$ are respectively connected to negative potential source $V_{ss}$ and positive potential source $V_{cc}$, and the flip-flop circuit is latched to amplify the potential difference between the node $P_1$ and $P_2$ up to the full logic level. In the above operation, timing when the second clock signal $CLK_p$ turns to low level may be same that when the first clock signal $CLK_n$ turns to high level, as far as it does not precede the latter.

The full logic level signals output simultaneously from the three sense amplifiers are input to a decoder as shown in Fig. 5 and processed to provide a data represented by two binary bits. For instance, when assuming that each sense amplifier outputs a signal "1" if the level of the read-out signal D is higher than the level of its reference voltage Ref, and "0" if the level of the D is lower than that of the Ref, there may be four combinations of the output signals from the three sense amplifiers, i.e. 111, 110, 100 and 000. They are related to the four states each represented by two bits of binary code, respectively, i.e. 11, 10, 01 and 00. The relation among the levels of the read-out signal D and the reference voltage Ref, the above combination of the output signal and the state represented by two binary bits is summarized in the following.

| Read-out signal | Output signal | State |
|---|---|---|
| $D>Ref_1$ | 111 | 11 |
| $Ref_1>D>Ref_2$ | 110 | 10 |
| $Ref_2>D>Ref_3$ | 100 | 01 |
| $Ref_3>D$ | 000 | 00 |

As described in the above embodiment, the flip-flop circuit in the present invention is not only kept inactive by the isolation of the common source of the p-channel transistors from the positive potential source during the stand-by sequence, but it is, meanwhile, rather powered to accelerate the change of the potential at the input/output nodes by implementing a means for supplying each common source of the p-channel transistors and the n-channel transistors with respective inverted potential. Hence, the operational speed can be maintained high even in the sense amplifier responsive to discriminate a read-out voltage signal of the lowest level in a multi-level ROM. In other words, sufficient potential difference is provided between the nodes $P_1$ and $P_2$ in a relatively short period during stand-by sequence, therefore, sensitivity of a flip-flop type sense amplifier can be improved without sacrifice of the operational speed.

The many features and advantages of the present invention are apparent from the detailed specification, and thus, it is intended by the appended claims to cover all such features and advantages of the device which fall within the true scope of the invention. Further, since modifications and changes will readily occur to those skilled in the art, it is not desired to limit the invention to the exact construction and operation illustrated and described, and accordingly, all suitable modifications and equivalents may be restored to, falling within the scope of the invention. For example, the above embodiment discloses the application to a multi-level ROM, however, the sense amplifier of the present invention can also be used in an ordinary two-level ROM or RAM.

**Claims**

1. A sense amplifier comprising:

a flip-flop circuit having a common source of a couple of n-channel MOS (Metal Oxide Semiconductor) transistors ($Q_1$, $Q_2$) and a common source of a couple of p-channel MOS transistors ($Q_3$, $Q_4$), each one of said n-channel MOS transistor ($Q_1$, resp $Q_2$) and said p-channel transistor ($Q_3$, resp $Q_4$) forming a pair ($Q_1$, $Q_3$ resp $Q_2$, $Q_4$) having a conduction channel connected in series and having a common gate connected to the node ($P_2$, resp $P_1$) of opposite pair ($Q_2$, $Q_4$ resp $Q_1$, $Q_3$) of said n-channel MOS transistor ($Q_2$ resp $Q_1$) and said p-channel transistor ($Q_4$ resp $Q_3$); said sense amplifier being characterised in that it further comprises:

a first switching circuit ($Q_5$, $Q_6$) for switching polarity of the potential supplied to said common source of said n-channel MOS transistors ($Q_1$, $Q_2$) consituting said flip-flop circuit; and

a second switching circuit ($Q_{11}$, $Q_{12}$) for switching polarity of the potential supplied to said common source of said p-channel MOS transistors ($Q_3$, $Q_4$) constituting said flip-flop circuit;

wherein the potentials at the common sources of said n-channel MOS transistors ($Q_1$, $Q_2$) and at the common source of said p-channel MOS transistors ($Q_3$, $Q_4$) are of mutually opposite polarities and are inverted in response to the transition between stand-by sequence and latching operation.

2. A sense amplifier as set forth in claim 1, characterized in that it further comprises:

a first buffer circuit including a couple of n-channel MOS transistors ($Q_7$, $Q_8$) having conduction channels connected in series between a positive potential source ($V_{cc}$) and a negative potential source ($V_{ss}$) having a couple of gates one of which is for receiving read-out voltage signals (D) from memory cells and the other is connected to the positive potential source ($V_{cc}$), and having a junction connected to said first node ($P_1$) of said flip-flop circuit; and

a second buffer circuit including a couple of n-channel MOS transistors ($Q_9$, $Q_{10}$) having conduction/ channels connected in series between a positive potential source ($V_{cc}$) and a negative potential source ($V_{ss}$), having a couple of gates one of which is for receiving a reference voltage (Ref) and the other is connected to

the positive potential source ($V_{cc}$), and having a junction connected to said second node ($P_2$) of said flip-flop circuit.

3. A sense amplifier as set forth in claims 1 or 2, characterized in that each of said first and second switching circuits ($Q_5$, $Q_6$; $Q_{11}$, $Q_{12}$) comprises a CMOS inverter having a conduction channel connected between a positive potential source ($V_{cc}$) and a negative potential source ($V_{ss}$), and said CMOS inverter constituting said first switching circuit ($Q_5$, $Q_6$) has a gate for receiving a first clock signal ($CLK_n$) and a junction connected to said common source of said n-channel transistors ($Q_1$, $Q_2$) of said flip-flop circuit, and said CMOS inverter constituting said second switching circuit ($Q_{11}$, $Q_{12}$) has a gate for receiving a second clock signal ($CLK_p$) and a junction connected to said common source of said p-channel transistors ($Q_3$, $Q_4$) of said flip-flop circuit.

**Patentansprüche**

1. Leseverstärker mit einer Flipflopschaltung, die eine gemeinsame Source eines Paares von n-Kanal-MOS-(Metalloxidhalbleiter)-Transistoren ($Q_1$, $Q_2$) und eine gemeinsame Source eines Paares von p-Kanal-MOS-Transistoren ($Q_3$, $Q_4$) umfaßt, bei dem jeweils ein genannter n-Kanal-MOS-Transistor ($Q_1$, bzw. $Q_2$) und ein genannter p-Kanal-Transistor ($Q_3$, bzw. $Q_4$) ein Paar ($Q_1$, $Q_3$ bzw. $Q_2$, $Q_4$) bilden, welches einen in Reihe verbundenen Leitungskanal und ein gemeinsames Gate hat, welches mit dem Knoten ($P_2$, bzw. $P_1$) des entgegengesetzten Paares ($Q_2$, $Q_4$ bzw. $Q_1$, $Q_3$) aus dem genannten n-Kanal-MOS-Transistor ($Q_2$ bzw. $Q_1$) und dem genannten p-Kanal-Transistor ($Q_4$ bzw. $Q_3$) verbunden ist; welcher genannte Leseverstärker dadurch gekennzeichnet ist, daß er ferner umfaßt:

einen ersten Schaltkreis ($Q_5$, $Q_6$), um die Polarität des Potentials zu schalten, welches der gemeinsamen Quelle der genannten n-Kanal-MOS-Transistoren ($Q_1$, $Q_2$) zugeführt wird, die die Flipflopschaltung bilden; und

einen xweiten Schaltkreis ($Q_{11}$, $Q_{12}$), um die Polarität des Potentials zu schalten, das der gemeinsamen Quelle der genannten p-Kanal-MOS-Transistoren ($Q_3$, $Q_4$) zugeführt wird, welche die genannte Flipflopschaltung bilden;

wobei die Potentiale an der gemeinsamen Quelle der genannten n-Kanal-MOS-Transistoren ($Q_1$, $Q_2$) und an der gemeinsamen Quelle der genannten p-Kanal-MOS-Transistoren ($Q_3$, $Q_4$) von wechselseitig entgegengesetzter Polarität sind und in Abhängigkeit von dem Übergang zwischen Bereitschaftssequenz und Haltebetriebs invertiert werden.

2. Leseverstärker nach Anspruch 1, dadurch gekennzeichnet, daß er ferner umfaßt:

eine erste Pufferschaltung, die ein Paar von n-Kanal-MOS-Transistoren ($Q_7$, $Q_8$) hat, die Leitungskanäle haben, die in Reihe zwischen einer positiven Potentialquelle ($V_{cc}$) und einer negativen Potentialquelle ($V_{ss}$) verbunden sind, und ein Paar von Gates haben, von denen eines zum Empfang der von Speicherzellen ausgelesenen Spannungssignale (D) und das andere mit der positiven Potentialquelle ($V_{cc}$) verbunden ist, und einen Koppelpunkt haben, der mit dem genannten ersten Knoten ($P_1$) der genannten Flipflopschaltung verbunden ist; und

eine zweite Pufferschaltung, mit einem Paar von n-Kanal-MOS-Transistoren ($Q_9$, $Q_{10}$), die Leitungskanäle haben, die in Reihe zwischen einer positiven Potentialquelle ($V_{cc}$) und einer negativen Potentialquelle ($V_{ss}$) verbunden sind, ein Paar von Gates haben, von denen eines zum Empfang einer Referenzspannung (Ref) und das andere mit der positiven Potentialquelle ($V_{cc}$) verbunden ist, und einen Koppelpunkt haben, der mit dem genannten Knoten ($P_2$) der genannten Flipflopschaltung verbunden ist.

3. Leseverstärker nach Anspruch 1 oder 2, dadurch gekennzeichnet, daß jeder der genannten ersten und zweiten Schaltkreise ($Q_5$, $Q_6$; $Q_{11}$, $Q_{12}$) einen CMOS-Inverter hat, der einen Leitungskanal hat, der zwischen einer positiven Potentialquelle ($V_{cc}$) und einer negativen Potentialquelle ($V_{ss}$) verbunden ist, und der genannte CMOS-Inverter, der den genannten ersten Schaltkreis ($Q_5$, $Q_6$) bildet, ein Gate zum Empfang eines ersten Taktsignals ($CLK_n$) und einen Koppelpunkt hat, der mit der genannten Source der genannten n-Kanal-MOS-Transistoren ($Q_1$, $Q_2$) der genannten Flipflopschaltung verbunden ist, und der genannte CMOS-Inverter, der den genannten zweiten Schaltkreis ($Q_{11}$, $Q_{12}$) bildet, ein Gate zum Empfang eines zweiten Taktsignals ($CLK_p$) und einen Koppelpunkt hat, der mit der gemeinsamen Source der genannten p-Kanal-Transistoren ($Q_3$, $Q_4$) der genannten Flipflopschaltung verbunden ist.

**Revendications**

1. Amplificateur de lecture comprenant:

un circuit de bascule possédant une source commune pour deux transistors MOS (métal-oxyde-semiconducteur) à canal n ($Q_1$, $Q_2$) et une source commune pour deux transistors MOS à canal p ($Q_3$, $Q_4$), l'un respectif desdits transistors MOS à canal n ($Q_1$, respectivement $Q_2$) et l'un respectif desdits transistors à canal p ($Q_3$, respectivement $Q_4$) formant une paire ($Q_1$, $Q_3$, respectivement $Q_2$, $Q_4$) possédant un canal de conduction connecté en série et ayant une grille commune connectée au noeud ($P_2$, respectivement $P_1$) de la paire opposée ($Q_2$, $Q_4$, respectivement $Q_1$, $Q_3$) dudit transistor MOS à canal n ($Q_2$, respectivement $Q_1$) et dudit transistor à canal p ($Q_4$, respectivement $Q_3$);

ledit amplificateur de lecture étant caractérisé en ce qu'il comprend en outre:

un premier circuit de commutation ($Q_5$, $Q_6$) servant à faire commuter la polarité du potentiel fourni à ladite source commune desdits transistors MOS à canal n ($Q_1$, $Q_2$) constituant ledit circuit de bascule; et

un deuxième circuit de commutation ($Q_{11}$, $Q_{12}$) servant à faire commuter la polarité du potential fourni à ladite source commune desdits transistors MOS à canal p ($Q_3$, $Q_4$) constituant ledit circuit de bascule;

où les potentiels présents sur la source commune desdits transistors MOS à canal n ($Q_1$, $Q_2$) et sur la source commune desdits transistors MOS à canal p ($Q_3$, $Q_4$) sont de polarités mutuellement opposées et sont inversés en réponse à la transition entre la séquence d'attente et l'opération de verrouillage.

2. Amplificateur de lecture selon la revendication 1, caractérisé en ce qu'il comprend en outre:

un premier circuit tampon comportant deux transistors MOS à canal n ($Q_7$, $Q_8$) possédant des canaux de conduction connectés en série entre une source de potentiel positif ($V_{cc}$) et une source de potentiel négatif ($V_{ss}$), possédant un couple de grilles dont l'une est destinée à recevoir les signaux de tension lus (D) en provenance de cellules de mémoire et l'autre est connectée à la source de potentiel positif ($V_{cc}$), et possédant une jonction qui est connectée audit premier noeud ($P_1$) dudit circuit de bascule; et

un deuxième circuit tampon comportant deux transistors MOS à canal n ($Q_9$, $Q_{10}$) possédant des canaux de conduction connectés en série entre une source de potentiel positif ($V_{cc}$) et une source de potentiel négatif ($V_{ss}$), possédant un couple de grilles dont l'une est destinée à recevoir une tension de référence (Ref) et l'autre est connectée à la source de potentiel positif ($V_{cc}$), et possédant une jonction connectée audit deuxième noeud ($P_2$) dudit circuit de bascule.

3. Amplificateur de lecture selon la revendication 1 ou 2, caractérisé en ce que chacun desdits premier et deuxième circuits de commutation ($Q_5$, $Q_6$; $Q_{11}$, $Q_{12}$) comprend un inverseur CMOS possédant un canal de conduction connecté entre une source de potentiel positif ($V_{cc}$) et une source de potentiel négatif ($V_{ss}$), ledit inverseur CMOS constituant ledit premier circuit de commutation ($Q_5$, $Q_6$) possède une grille destinée à recevoir un premier signal d'horloge ($CLK_n$) et une jonction connectée à ladite source commune desdits transistors à canal n ($Q_1$, $Q_2$) dudit circuit de bascule, et ledit inverseur CMOS constituant ledit deuxième circuit de commutation ($Q_{11}$, $Q_{12}$) possède une grille destinée à recevoir un deuxième signal d'horloge ($CLK_p$) et une jonction connectée à ladite source commune desdits transistors à canal p ($Q_3$, $Q_4$) dudit circuit de bascule.

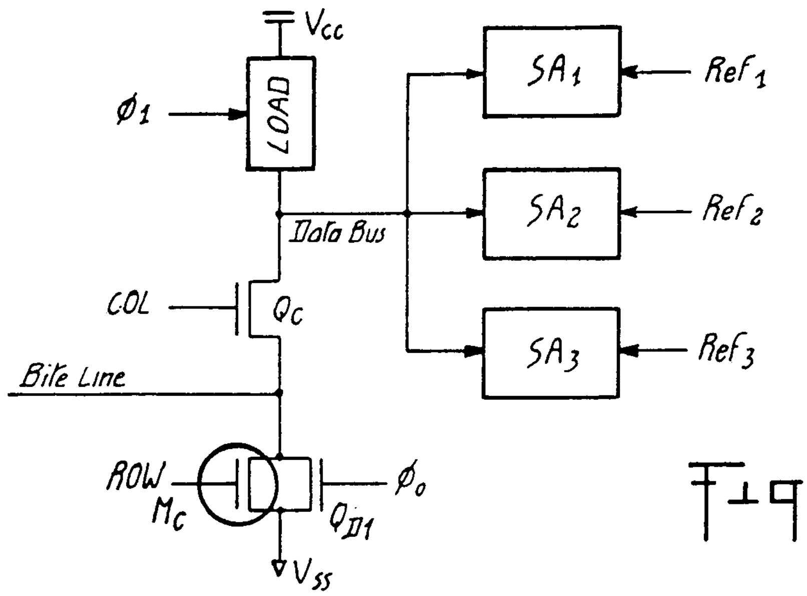
Vcc
Ø1
LOAD
SA1
SA2
SA3
Ref1
Ref2
Ref3
Data Bus
COL
Qc
Bite Line
ROW
Mc
Ø0
QD1
Vss

Fig. 1

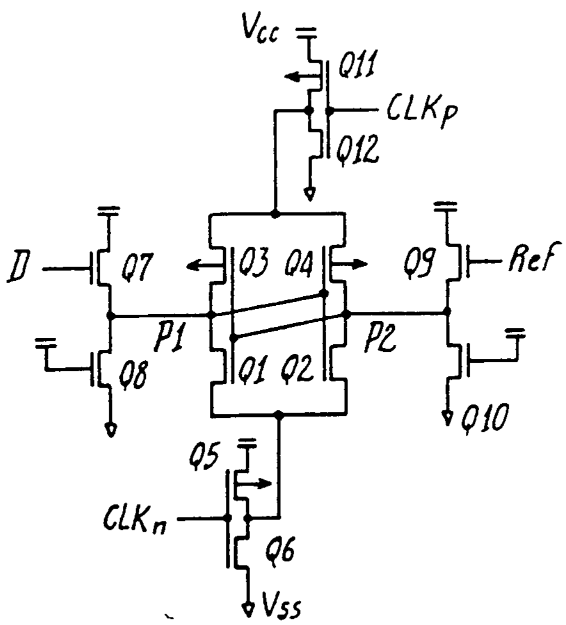
Vcc
Q11
CLKp
Q12
D
Q7
Q3
Q4
Q9
Ref
P1
P2
Q8
Q1
Q2
Q10
Q5
CLKn
Q6
Vss

Fig. 2

Fig. 3

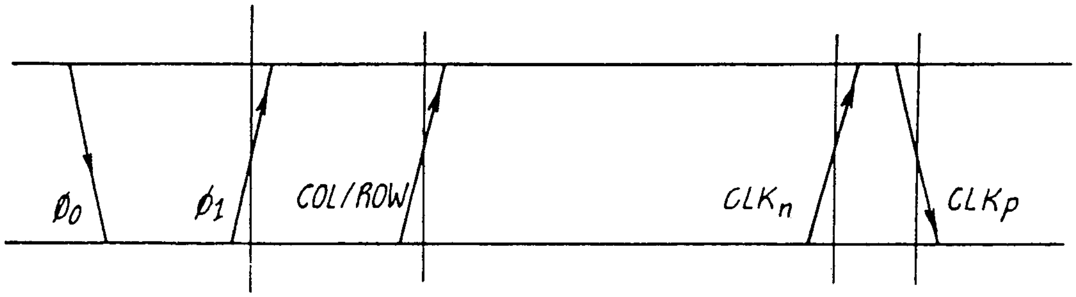


Fig. 4(A)

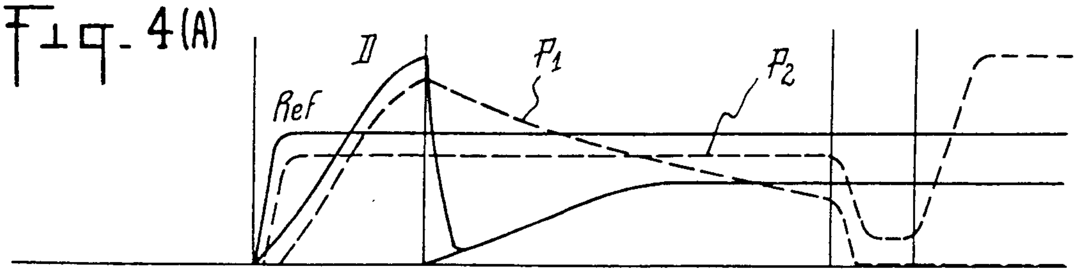


Fig. 4 (B)

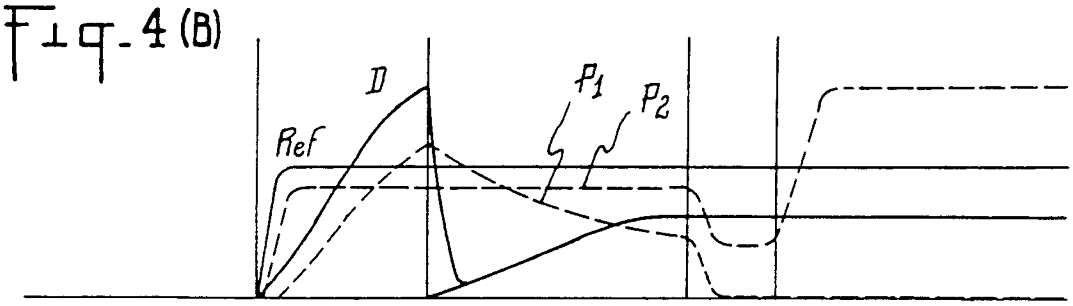


Fig. 5